# EUROPÄISCHE PATENTSCHRIFT

(11) **EP 1 223 231 B1**
(45) Veröffentlichungstag und Bekanntmachung des Hinweises auf die Patenterteilung: **11.02.2004**
(21) Anmeldenummer: 01129044.2
(22) Anmeldetag: 07.12.2001
(51) Int. Cl.: C23C 14/50, C23C 14/54

(54) **Vorrichtung zur Aufnahme eines optischen Elementes aus einem kristallinen Material während eines Aufdampfprozesses**
Device for holding an optical element made from a cristalline material during a vapor deposition process
Dispositif pour le support d'un élément optique en matériau cristallin pendant un procédé de dépot en phase vapeur

(30) Priorität: 05.01.2001 DE 10100328
(43) Veröffentlichungstag der Anmeldung: 17.07.2002
(73) Patentinhaber: CARL ZEISS SEMICONDUCTOR MANUFACTURING TECHNOLOGIES AG, 73447 Oberkochen (DE)
(72) Erfinder: Hartmaier, Jürgen, Dipl.-Phys., 73432 Aalen (DE); Klaassen, Dietrich, Dipl.-Ing., 73447 Oberkochen (DE); Böhm, Thure, Dr., 73430 Aalen (DE); Wergl, Bernhard, Dr., 89555 Steinheim (DE); Gerhard, Michael, Dr., 73432 Aalen (DE); Spanuth, Jens, Dipl.-Phys., 73431 Aalen (DE); Kuschnereit, Ralf, Dr., 73447 Oberkochen (DE); Vogt, Peter, Entw.-Ing., 89522 Heidenheim (DE); Bauer, Harry, 73432 Aalen (DE)
(74) Vertreter: Lorenz, Werner, Dr.-Ing.

(56) Entgegenhaltungen:
- EP-A- 0 215 261
- EP-A- 0 743 377
- CH-A- 679 838
- DE-A- 4 446 179
- DE-C- 19 932 338
- US-A- 5 527 393
- PATENT ABSTRACTS OF JAPAN vol. 1998, no. 04, 31. März 1998 (1998-03-31) & JP 09 316648 A (NIKON CORP), 9. Dezember 1997 (1997-12-09)
- PATENT ABSTRACTS OF JAPAN vol. 1998, no. 06, 30. April 1998 (1998-04-30) & JP 10 036971 A (NIKON CORP), 10. Februar 1998 (1998-02-10)

## Beschreibung

Die Erfindung betrifft eine Vorrichtung zur Aufnahme eines optischen Elements, insbesondere aus einem kristallinen Material, nach der im Oberbegriff von Anspruch 1 näher definierten Art.

Im allgemeinen werden optische Elemente sehr häufig mit Funktionsschichten zur Verbesserung der optischen Qualität, beispielsweise Antireflexschichten oder dergleichen, beschichtet. Üblicherweise erfolgt diese Beschichtung in einer Vakuumbeschichtungsanlage, in welche die optischen Elemente eingebracht und in welcher sie erwärmt werden, während gleichzeitig die Stoffe für die entsprechende Funktionsschicht zugeführt werden. Die Stoffe für die entsprechende Funktionsschicht lagern sich dann auf den Oberflächen der optischen Elemente ab. Um eine möglichst gleichmäßige Ablagerung auf den Oberflächen der optischen Elemente zu erreichen, werden diese in entsprechenden Halterungen zur Aufnahme der optischen Elemente eingelegt und im allgemeinen in der Vakuumbeschichtungsanlage bewegt.

Da nun derartige Linsen oder andere optische Elemente aus kristallinen Materialien, welche beispielsweise in der Halbleiter-Lithographie-Technik eingesetzt werden, relativ große Durchmesser aufweisen und vergleichsweise schwer sind, sind diese Einrichtungen zur Halterung der optischen Elemente in der Vakuumbeschichtungsanlage mit den entsprechenden angetriebenen Achsen aus hochfesten Materialien ausgeführt, um beispielsweise vier oder mehr Linsen gleichzeitig in der Vakuumbeschichtungsanlage beschichten zu können, ohne daß die Halterungen durch die Gewichtsbelastung zusammen mit der auftretenden thermischen Belastung versagen. Die Halteelemente sind dazu im allgemeinen aus einem hochfesten Metall, beispielsweise Stahl, ausgeführt.

Nun müssen aufgrund des Vakuums bzw. wenigstens annähernd vollständigen Vakuums entsprechende Strahler eingesetzt werden, um ein Aufheizen der optischen Elemente zu gewährleisten, da Wärmeübertragung durch Konvektion oder dergleichen im Vakuum nicht genutzt werden kann. Bei diesen Strahlern, üblicherweise handelt es sich um Infrarotstrahler, besteht nun jedoch das Problem, daß diese auch die die optischen Elemente umgebenden Bauteile, welche wie eingangs bereits erwähnt üblicherweise aus Stahl ausgeführt sind, sehr stark erwärmen. So kommt es zu einem sehr großen Temperaturunterschied zwischen den Einrichtungen zur Halterung des optischen Elements und dem optischen Element selbst, welcher zu einem Temperaturgradienten innerhalb des optischen Elements führt.

Damit entsteht im Bereich der Auflage des optischen Elements auf den Halterungen ein sehr großer punktueller Wärmeeintrag, da hier von den Halterungen, welche im allgemeinen die Wärme besser aufnehmen als das optische Element, eine sehr große thermische Energie in das optische Element eingeleitet wird, welche von diesem, da kristalline Materialien der eingangs erwähnten Art im allgemeinen schlechtere Wärmeleiter als Stahl sind, nur ungenügend abtransportiert und in dem Element verteilt werden kann. Es stellt sich damit also auch in dem optischen Element selbst ein sehr großer Temperaturgradient ein, welcher zu hohen thermischen Spannungen in dem optischen Element führt. Üblicherweise findet diese Erhöhung der thermischen Spannung in einem Bereich statt, in dem ohnehin durch die Auflage des optischen Elements auf den Einrichtungen zu dessen Halterung bereits sehr hohe Spannungseinträge aufgrund der Gravitationskräfte auf das optische Element wirken. Es kann daher sehr leicht passieren, daß in diesen Bereichen des optischen Elements eine kritische Schubspannung durch die Addition aus Gravitationsspannung und thermisch induzierter Spannung überschritten wird. Dies kann bei kristallinen Materialien zu einem Versatz der Gitterebenen oder dergleichen führen, was die optischen Elemente für weitere Anwendungen im Bereich der Hochleistungsoptik unbrauchbar macht, da eine plastische Verformung auftritt.

Die US 5,527,393 A offenbart eine Dampfphasenabscheidungsvorrichtung zur Beschichtung eines Kristallsubstrates, um eine gleichmäßige Oberflächentemperaturverteilung zu ermöglichen. Hierfür wird ein Zwischenelement vorgesehen, welches zwischen einer Halteeinrichtung und dem Kristallsubstrat angeordnet wird. Das Kristallsubstrat wird über das Zwischenelement getragen, welches wiederum seinerseits mit der Halteeinrichtung über dünne Tragpfosten verbunden ist. Das Zwischenelement und die Tragpfosten bilden somit lange Wärmestrecken jeweils einer kleinen Querschnittsfläche. Durch diese Anordnung ist die Wärme, die von der Halteeinrichtung.auf das Kristallsubstrat über diese Wärmestrecken übertragen wird, vernachlässigbar klein und wesentlich geringer als die von der Halteeinrichtung zum Kristallsubstrat abgestrahlte Wärme. Eine wichtige Voraussetzung einer derart gleichmäßigen Oberflächentemperatur ist, dass das Zwischenelement in wesentlichen die gleiche Emissivität oder die gleiche Rauhheit oder die gleiche Wärme kapazität wie das Substrat aufweist.

Des weiteren offenbart der Patent Abstracts of Japan 09316648 ein Plasma-CVD-System zur Beschichtung von optischen Elementen, welche hauptsächlich durch Strahlung aufgeheizt werden. Das optische Element wird auf Halterungen angeordnet, welche wiederum mit einer heißen Grundplatte verbunden sind.

Aus der DE 199 32 338 C1 ist eine Vorrichtung zum Rotieren eines mit keramischen und metallischen Substanzen zu beschichtenden Substrates bekannt. Die Vorrichtung besteht aus einem zweiseitigen Kugellager aus zwei Ringscheiben, zwischen denen sich ein ringförmiger Substrathalter, durch Kugeln von beiden getrennt, drehen kann. Die Ringscheiben und der Substrathalter sind aus einer Edelstahllegierung und die Kugeln aus einem keramischen Material, wie beispielsweise Al₂O₃, hergestellt. Die Kugeln aus Al₂O₃ erfüllen somit die Anforderungen wie Härte, Abriebfestigkeit und schlechte thermische Leitfähigkeit zur thermischen Entkopplung. Die Vorrichtung lässt somit eine freistehende Rotation des Substrathalters zu, was dazu führt, dass beide Trägerflächen gleichzeitig beschichtet werden können.

Es ist daher die Aufgabe der Erfindung, eine Vorrichtung zu schaffen, welche zur Aufnahme eines optischen Elements, insbesondere aus einem kristallinen Material, während einer Beschichtung des optischen Elements durch Aufdampfen von wenigstens einer Funktionsschicht in.einer Vakuumbeschichtungsanlage dient, und welche den Eintrag von thermischen Belastungen in das optische Element minimiert.

Erfindungsgemäß wird diese Aufgabe durch die Merkmale des Anspruches 1 gelöst.

Dadurch, daß ein Zwischenelement eingesetzt wird, welches eine geringere Wärmeaufnahme als die Einrichtung zur Halterung des optischen Elements aufweist und aus einem Material ausgebildet ist, welches die geeignete Strahlung weniger stark absorbiert als die Einrichtung zur Halterung des optischen Elements, wird erreicht, daß die Zwischen elemente sich weniger stauh aufheizen als die Halterungen. Der Eintrag von thermischer Energie in diese ohnehin sehr kritischen Bereiche des optischen Elements im Bereich seiner Auflage wird vermieden, die Addition aus thermisch induzierten Spannungen und durch die Gravitation eingebrachten Spannungen in dem Kristall des optischen Elements bleibt damit im allgemeinen unter einer kritischen Schubspannung, welche eine plastische Verformung des optischen Elements bewirken könnte.

In einer besonders günstigen Ausgestaltung der Erfindung ist das Zwischenelement außerdem über Auflageelemente aus einem schlecht wärmeleitenden Material mit der Einrichtung zur Halterung des optischen Elements verbunden.

Damit entsteht ein weiterer Vorteil. Hier kann der Eintrag von thermischer Energie von den Halterungen auf das Zwischenelement und damit auch auf das optische Element praktisch vollkommen unterbunden werden, da die entsprechenden Auflageelemente, diese können beispielsweise aus Kügelchen aus Keramik oder dergleichen ausgebildet sein, die Wärme, insbesondere auch aufgrund ihrer geringen Auflagefläche, praktisch nicht in das Zwischenelement und damit in das optische Element weitergeben.

In einer weiteren sehr günstigen Ausführungsform der Erfindung weist das Zwischenelement außerdem eine für die zur Erwärmung des optischen Elements genutzte Strahlung reflektierende Beschichtung auf.

Diese Beschichtung, welche beispielsweise aus Gold oder dergleichen sein kann, reflektiert die zur Erwärmung des optischen Elements genutzte Strahlung praktisch vollständig, so daß sich das Zwischenelement, welches in einer besonders günstigen Kombination der beiden beschriebenen Ausführungsformen außerdem über die Auflageelemente thermisch von den Halterungen entkoppelt ist, praktisch nicht oder jedenfalls nicht mehr als das optische Element selbst erwärmt. Der Eintrag von thermisch induzierten Spannungen in das optische Element, welche aufgrund von lokalen Erwärmungen und damit verbundenen hohen Temperaturunterschieden zwischen den einzelnen Punkten des optischen Elements verursacht werden, kann damit praktisch vollständig ausgeschlossen werden. Eine Beschichtung des optischen Elements mit einer oder mehreren entsprechenden Funktionsschichten ist dann problemlos möglich, ohne daß eine Beeinträchtigung der optischen Qualität des optischen Elements aufgrund von gegeneinander versetzten Gitterebenen oder dergleichen, also plastische Verformung, befürchtet werden muß.

Ein weiterer Vorteil besteht darin, daß das Zwischenelement so ausgeführt werden kann, daß es eine sehr gute Wärmeleitfähigkeit und dabei eine sehr geringe Wärmekapazität aufweist. Damit kann dann erreicht werden, daß sich das Zwischenelement praktisch immer auf derselben Temperatur wie das optische Element befindet, da Wärmeunterschiede durch dessen gute Wärmeleitfähigkeit sehr schnell ausgeglichen werden. Durch die gleichzeitig sehr kleine Wärmekapazität, welche beispielsweise durch eine relativ dünne Ausführung des Zwischenelements mit einer sehr kleinen Masse erreicht werden kann, kommt es im Bereich des Zwischenelements auch kaum zu Speichereffekten, welche die Temperaturunterschiede zeitlich verschleppen.

Grundlegend wären hier natürlich auch Zwischenelemente aus entsprechenden, temperaturbeständigen Kunststoffen denkbar, da diese sehr vorteilhafte Eigenschaften hinsichtlich Wärmekapazität und Wärmeleitung mit sehr günstigen mechanischen Eigenschaften verbinden würden. Dann sollte jedoch sichergestellt werden, daß in der Vakuumbeschichtungsanlage keine organischen Stoffe von den Kunststoffen abdampfen können, welche sich gegebenenfalls auf dem optischen Element niederschlagen und eine Beeinträchtigung der zu erzielenden Qualität einer Funktionsbeschichtung des optischen Elements verursachen könnten.

Weitere vorteilhafte Ausgestaltungen ergeben sich aus den restlichen Unteransprüchen und dem anhand der Zeichnungen nachfolgenden Ausführungsbeispiel.

Es zeigt:
- Figur 1: eine stark schematisierte Vakuumbeschichtungsanlage in einem prinzipmäßigen Querschnitt; und
- Figur 2: einen Querschnitt durch einen Teil einer Einrichtung zur Halterung des zu beschichtenden optischen Elements, gemäß der Linie II-II in Figur 1.

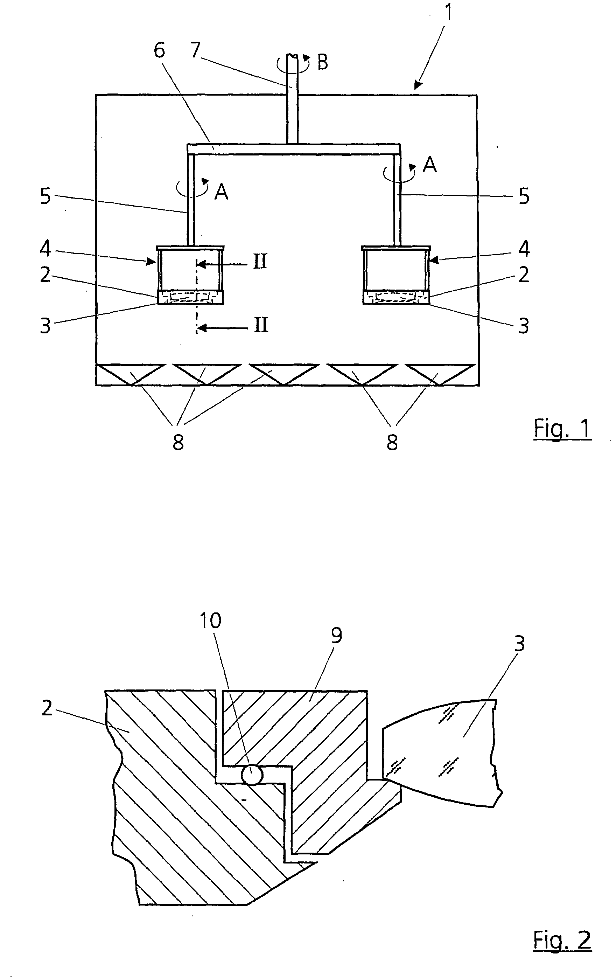

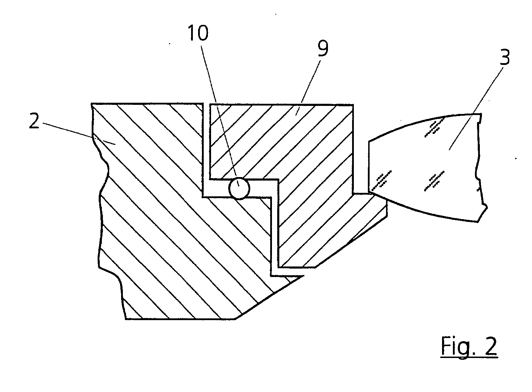

In Figur 1 ist eine Vakuumbeschichtungsanlage 1 in einer sehr stark schematisierten Darstellung angedeutet. Im Inneren der Vakuumbeschichtungsanlage 1 sind zwei Einrichtungen 2 zur Halterung je eines optischen Elements 3 prinzipmäßig dargestellt. Die Einrichtungen 2 zur Halterung des optischen Elements 3 sind dabei über einen Aufnahmemechanismus 4 jeweils mit einer Welle 5 verbunden, welche jeweils gemäß den Pfeilen A rotieren. Diese Einheit aus Aufnahmemechanismus 4, Welle 5 und Einrichtung 2 zur Halterung des optischen Elements 3 ist dann an einem Querträger 6 befestigt, welcher wiederum um eine Achse 7 gemäß dem Pfeil B rotiert. Die einzelnen optischen Elemente 3 führen so zykloidische Bewegungen aus, wodurch eine gleichmäßige Beschichtung der Oberfläche der optischen Elemente erreicht werden kann. Üblicherweise sind mehr als zwei der optischen Elemente über die entsprechenden Bauteile 5, 4, 2 an dem Querträger 6 befestigt, so daß vier oder mehr optische Elemente 3 gleichzeitig in der Vakuumbeschichtungsanlage 1 mit einer Obenflächenschicht, beispielsweise einer Anti-Reflex-Beschichtung, versehen werden können.

Um die optischen Elemente 3 trotz des Vakuums in der Vakuumbeschichtungsanlage 1 für die Bedampfung mit der entsprechenden Funktionsschicht aufheizen zu können, weist die Vakuumbeschichtungsanlage 1 mehrere Strahler 8 auf, welche hier prinzipmäßig angedeutet sind. Über die von den Strahlern 8 ausgehende Strahlung werden die optischen Elemente 3 auf die für die Bedampfung erforderliche Temperatur aufgeheizt. Üblicherweise handelt es sich bei den Strahlern 8 um Infrarotstrahler, es sind jedoch je nach zu beschichtenden optischen Elementen 3 auch andere Wellenlängen der Strahlung denkbar, welche jeweils zu der Erwärmung des optischen Elements 3 führen.

Gleichzeit erwärmen die Strahler 8 über ihre Strahlung selbstverständlich auch den Aufbau aus den Einrichtungen 2 zur Halterung der optischen Elemente 3, den Aufnahmemechanismus 4, die Wellen 5, den Querträger 6 sowie die Achse 7. Aufgrund der thermischen und mechanischen Beanspruchungen dieser Elemente sind diese üblicherweise aus einem hochfesten Material, beispielsweise Stahl, ausgeführt und erwärmen sich weitaus stärker als das eigentlich aufzuheizende optische Element 3.

Bei den bisherigen Anlagen kommt es so zu einem großen Temperaturunterschied zwischen den Einrichtungen 2 zur Halterung des optischen Elements 3 und dem optischen Elements 3 selbst. Im Bereich der Auflage des optischen Elements 3 auf den Einrichtungen 2 entsteht über Wärmeleitung eine hohe punktuelle Erwärmung des optischen Elements 3, welche sich in diesem aufgrund seiner im allgemeinen vergleichsweise schlechten Wärmeleitfähigkeit nur ungenügend ausbreiten kann. Die Folge sind sehr hohe Spannungen in Folge des Temperaturgradienten, welche außerdem in dem Bereich liegen, in dem aufgrund der Auflage des optischen Elements 3 auf den Einrichtungen 2 zu dessen Halterung bereits sehr hohe Spannungseinträge durch die Gravitationskraft auf das optische Element 3 wirken.

Werden nun hochwertige optische Elemente 3 aus kristallinem Materialien, vorzugsweise aus Fluoriden, beispielsweise Kalziumfluorid beschichtet, es ist hier jedoch auch die Beschichtung anderer Einkristalle beispielsweise aus Germanium oder dergleichen denkbar, so kann es aufgrund der Überlagerung von thermisch induzierten Spannungen und durch die Gravitation verursachten Spannungen zu einer sehr großen Schubspannung in dem kritischen Bereich der Auflage des optischen Elements 3 kommen. Durch diese hohe Schubspannung können sich einzelne Gitterebenen des kristallinen optischen Elements 3 gegeneinander verschieben, womit das optischen Element 3 für seinen geplanten Einsatzzweck unbrauchbar wird, da es dann plastisch verformt ist.

Bei der hier dargestellten Vorrichtung wird dies durch das in Figur 2 zu erkennende Zwischenelement 9 sowie entsprechende Auflageelemente 10 vermieden. Dazu ist das Zwischenelement 9 aus einem Material ausgebildet, das die zur Erwärmung genutzte Strahlung der Strahler 8 beispielsweise Infrarotstrahler weniger stark absorbiert als das optische Element 3 selbst. Dieses Material kann beispielsweise ein entsprechendes, verspiegeltes Material sein. Als besonders günstig hat sich ein mit einer reflektierenden Goldbeschichtung versehenes Zwischenelement 9 aus Aluminium herausgestellt. Das mit dem Gold verspiegelte Aluminium reflektiert den größten Teil der auftreffenden Infrarotstrahlung der Strahler 8 und erwärmt sich somit im Gegensatz zu den umgebenden Einrichtungen 2 weitaus weniger stark. Der Eintrag von thermischer Energie in den durch die Gravitationsspannungen ohnehin stark belasteten Randbereich des optischen Elements 3 durch das Zwischenelement 9 und durch die Einrichtungen 2 zur Halterung des optischen Elementes 3 kann somit vermieden werden.

Um nun das Zwischenelement 9 thermisch von der Einrichtung 2 zur Halterung des optischen Elements 3 zu entkoppeln, ist das Zwischenelement 9 über die Auflageelemente 10 auf der Einrichtung 2 abgestützt. Die Auflageelemente 10 sind dabei aus einem Material ausgeführt, welches die Wärme weitaus schlechter leitet als die üblicherweise aus Metall ausgeführten Einrichtung 2 und/oder das Zwischenelement 9.

Zusätzlich sind die Auflageelemente 10 in einer geometrischen Form ausgeführt, welche nur eine sehr geringe Auflagefläche zwischen dem Auflageelement 10 selbst und der Einrichtung 2 einerseits bzw. dem Zwischenelement 9 andererseits ausbilden. Hier kann beispielsweise an kegel-, zylinder- oder kugelförmige Elemente gedacht werden. Sind die Auflageelemente 10 dabei zusätzlich aus einem Material mit einer entsprechend schlechten Wärmeleitung, beispielsweise aus einer Keramik ausgebildet, so kann ein Wärmeeintrag in das optische Element 3 über Wärmeleitung von der Einrichtung 2 zur Halterung des optischen Elements 3 über die Auflageelemente 10 und das Zwischenelement 9 praktisch ausgeschlossen werden. Als besonders geeignet haben sich jedoch, insbesondere aufgrund ihrer idealen mechanischen Eigenschaften, Kugeln aus Rubin, als Auflageelemente 10 herausgestellt. Diese weisen zwar eine bessere Wärmeleitfähigkeit als Keramiken auf, aufgrund der sehr kleinen Auflagefläche der Kugeln funktioniert die thermische Entkopplung aber auch hier sehr gut. Die oben genannte Problematik bezüglich des Überschreitens der kritischen Schubspannung aufgrund der Addition von thermischen Spannungen und Gravitationsspannungen im Bereich der Auflage des optischen Elements 3 kann damit,vermieden werden.

Ist das Zwischenelement 9 wie oben beschrieben ein mit einer reflektierenden Goldbeschichtung versehener Aluminiumring, so ist dieser außerdem weicher als das üblicherweise für das optische Element 3 eingesetzte Material, beispielsweise Kalziumfluorid, so daß das Material des optischen Elements 3 keine Schäden durch Kratzer oder dergleichen davonträgt, welche bei derartigen kristallinen Materialien sehr leicht zu einem Gitterversatz, einer Spaltung oder dergleichen führen könnten.

Selbstverständlich wird das Zwischenelement 9 ebenfalls mit der durch die Vakuumbeschichtungsanlage 1 auf das optische Element 3 aufgetragenen Schicht bedampft, was beispielsweise bei einer Anti-Reflex-Beschichtung nach mehrmaligem Einsatz dazu führt, daß die Reflektion der zur Erwärmung genutzten Strahlung der Strahlen 8 nicht mehr vollkommen sichergestellt werden kann. Die Zwischenelemente 9 müssen dann gereinigt oder ersetzt werden.

Aufgrund dieser Überlegungen wäre hier der oben bereits angesprochene thermisch beständige Kunststoff ein sehr günstiges Material für den Zwischenring 9, da dieser relativ weich wäre und aufgrund des vergleichsweise kleinen Kostenaufwands bei seiner Herstellung als Wegwerfartikel ausgebildet werden könnte.

## Patentansprüche

1. Vorrichtung zur Aufnahme eines optischen Elements (3), insbesondere aus einem kristallinen Material, insbesondere aus CaF₂, während einer Beschichtung des optischen Elements (3) durch Aufdampfen wenigstens einer Funktionsschicht in einer Vakuumbeschichtungsanlage (1) mit einer Einrichtung (2) zur Halterung des optischen Elements (3), wobei das optische Element (3) in der Vakuumbeschichtungsanlage über eine geeignete Strahlung, insbesondere Infrarotstrahlung, erwärmbar ist, wobei zwischen der Einrichtung (2) zur Halterung des optischen Elements (3) und dem optischen Element (3) ein Zwischenelement (9) angeordnet ist, welches eine geringere Wärmeaufnahme als die Einrichtung (2) zur Halterung des optischen Elements (3) aufweist, wobei das Zwischenelement (9) aus einem Material ausgebildet ist, welches die geeignete Strahlung weniger stark absorbiert als die Einrichtung (2) zur Halterung des optischen Elements (3).

2. Vorrichtung nach Anspruch 1, **dadurch gekennzeichnet, daß** das Zwischenelement (9) über Auflageelemente (10) aus einem schlecht wärmeleitenden Material mit der Einrichtung (2) zur Halterung des optischen Elements (3) verbunden ist.

3. Vorrichtung nach Anspruch 1 oder 2, **dadurch gekennzeichnet, daß** das Zwischenelement (9) eine für die geeignete Strahlung reflektierende Beschichtung aufweist.

4. Vorrichtung nach einem der Ansprüche 1 bis 3, **dadurch gekennzeichnet, daß** das Zwischenelement (9) aus einem Material ausgebildet ist, welches weicher als das Material des optischen Elements (3) ist.

5. Vorrichtung nach Anspruch 3, **dadurch gekennzeichnet, daß** die reflektierende Beschichtung eine Goldbeschichtung ist.

6. Vorrichtung nach einem der Ansprüche 1 bis 4, **dadurch gekennzeichnet, daß** das Zwischenelement (9) aus Aluminium gebildet ist.

7. Vorrichtung nach Anspruch 2, **dadurch gekennzeichnet, daß** die Auflageelemente (10) als geometrische Körper mit einer geringen Kontaktfläche zumindest zu der Einrichtung (2) zur Halterung des optischen Elements (3) hin ausgebildet sind.

8. Vorrichtung nach Anspruch 2, **dadurch gekennzeichnet, daß** die Auflageelemente (10) als zylinderförmige Elemente ausgebildet sind.

9. Vorrichtung nach Anspruch 2, **dadurch gekennzeichnet, daß** die Auflageelemente (10) als kugelförmige Elemente ausgebildet sind.

10. Vorrichtung nach Anspruch 2, **dadurch gekennzeichnet, daß** die Auflageelemente (10) als kegelförmige Elemente ausgebildet sind.

11. Vorrichtung nach Anspruch 8, 9 oder 10, **dadurch gekennzeichnet, daß** die Auflageelemente (10) aus Rubin ausgebildet sind.

12. Vorrichtung nach Anspruch 2, **dadurch gekennzeichnet, daß** die Auflageelemente (10) aus Keramik ausgebildet sind.

## Claims

1. A device for holding an optical element (3) consisting, in particular, of a crystalline material, in particular of CaF₂, while the optical element (3) is being coated by vapour deposition of at least one functional coating in a vacuum coating apparatus (1), comprising an arrangement (2) for holding the optical element (3), the optical element (3) being heatable in the vacuum coating apparatus by means of suitable radiation, in particular infrared radiation, an intermediate element (9) which has lower heat-absorption than the arrangement (2) for holding the optical element (3) being arranged between the arrangement (2) for holding the optical element (3) and the optical element (3), and the intermediate element (9) being made of a material which absorbs the suitable radiation to a lesser degree than the arrangement (2) for holding the optical element (3).

2. Device according to claim 1, **characterised in that** the intermediate element (9) is connected to the device (2) for holding the optical element (3) by means of support elements (10) made of a material having poor thermal conductivity.

3. Device according to claim 1 or 2, **characterised in that** the intermediate element (9) has a coating which reflects the suitable radiation.

4. Device according to any one of claims 1 to 3, **characterised in that** the intermediate element (9) is made of a material which is softer than the material of the optical element (3).

5. Device according to claim 3, **characterised in that** the reflective coating is a gold coating.

6. Device according to any one of claims 1 to 4, **characterised in that** the intermediate element (9) is made of aluminium.

7. Device according to claim 2, **characterised in that** the support elements (10) are configured as geometrical bodies having a small contact area at least with the arrangement (2) for holding the optical element (3).

8. Device according to claim 2, **characterised in that** the support elements (10) are in the form of cylindrical elements.

9. Device according to claim 2, **characterised in that** the support elements (10) are in the form of spherical elements.

10. Device according to claim 2, **characterised in that** the support elements (10) are in the form of conical elements.

11. Device according to claim 8, 9 or 10, **characterised in that** the support elements (10) are made of ruby.

12. Device according to claim 2, **characterised in that** the support elements (10) are made of ceramics.

## Revendications

1. Dispositif pour supporter un élément optique (3), en particulier fait d'une matière cristalline, notamment de CaF₂, pendant une opération de revêtement de l'élément optique (3) par évaporation d'au moins une couche fonctionnelle dans une installation de revêtement sous vide (1), comprenant un support (2) servant à tenir l'élément optique (3), l'élément optique (3) pouvant être chauffé dans l'installation de revêtement sous vide au moyen d'un rayonnement approprié, en particulier d'un rayonnement infrarouge, dans lequel, entre le support (2) servant à tenir l'élément optique (3) et l'élément optique (3), est disposé un élément intermédiaire (9) qui présente une plus faible absorption de chaleur que le support (2) servant à tenir l'élément optique (3), l'élément intermédiaire (9) étant réalisé en une matière qui absorbe moins fortement le rayonnement approprié que le support (2) servant à tenir l'élément optique (3).

2. Dispositif selon la revendication 1, **caractérisé en ce que** l'élément intermédiaire (9) est relié au support (2) servant à tenir l'élément optique (3) par des éléments d'appui (10) réalisés en une matière mauvaise conductrice de la chaleur.

3. Dispositif selon la revendication 1 ou 2, **caractérisé en ce que** l'élément intermédiaire (9) comporte un revêtement réfléchissant pour le rayonnement approprié.

4. Dispositif selon l'une des revendications 1 à 3, **caractérisé en ce que** l'élément intermédiaire (9) est réalisé en une matière qui est plus tendre que la matière de l'élément optique (3).

5. Dispositif selon la revendication 3, **caractérisé en ce que** le revêtement réfléchissant est un revêtement d'or.

6. Dispositif selon l'une des revendications 1 à 4, **caractérisé en ce que** l'élément intermédiaire (9) est réalisé en aluminium.

7. Dispositif selon la revendication 2, **caractérisé en ce que** les éléments d'appui (10) sont constitués par des corps géométriques comportant au moins une petite surface de contact avec le support (2) servant à tenir l'élément optique (3).

8. Dispositif selon la revendication 2, **caractérisé en ce que** les éléments d'appui (10) sont constitués par des éléments cylindriques.

9. Dispositif selon la revendication 2, **caractérisé en ce que** les éléments d'appui (10) sont constitués par des éléments sphériques.

10. Dispositif selon la revendication 2, **caractérisé en ce que** les éléments d'appui (10) sont constitués par des éléments coniques.

11. Dispositif selon la revendication 8, 9 ou 10, **caractérisé en ce que** les éléments d'appui (10) sont réalisés en rubis.

12. Dispositif selon la revendication 2, **caractérisé en ce que** les éléments d'appui (10) sont réalisés en céramique.
